# EUROPEAN PATENT APPLICATION

(11) **EP 4 366 032 A1**
(43) Date of publication of application: **08.05.2024**
(21) Application number: 23205471.8
(22) Date of filing: 24.10.2023
(51) Int. Cl.: H01M 10/48, H01M 50/569, H01M 10/42, H01M 50/103, H01M 50/105, H01M 50/284, H01M 50/55, H01M 50/557, G01L 3/10, G01R 31/392

(54) **BATTERY PACK**

(30) Priority: 02.11.2022 KR 20220144580
(71) Applicant: Samsung SDI Co., Ltd., Yongin-si, Gyeonggi-do 17084 (KR)
(72) Inventor: Park, Sanghun, 17084 Yongin-si, Gyeonggi-do (KR)
(74) Representative: Gulde & Partner

(57) **Abstract**

A battery pack (1) includes a case (40) accommodating at least one cell therein, a strain gage (20) disposed at a surface of the case (40) and having a resistance value varied by a case displacement and a case temperature change, the strain gage (20) including a single resistor having the resistance value varied by the case displacement and the case temperature change, a plurality of first measurement points (21, 22) electrically connected to the resistor and used to detect a change in the resistance value of the resistor according to the case displacement, a plurality of second measurement points (23, 24) electrically connected to the resistor and used to detect a change in the resistance value of the resistor according to the case temperature change, the plurality of first measurement points (21, 22) and the plurality of second measurement points (23, 24) being spaced apart from each other.

## Description

### BACKGROUND

### 1. Field

A battery pack is disclosed.

### 2. Description of the Related Art

A secondary battery that may be repeatedly charged and discharged differs from a primary battery that provides only irreversible conversion of chemical energy to electrical energy. A low-capacity secondary battery is used as a power supply for a small electronic device such as a mobile phone, a laptop computer, or a camcorder, and a high-capacity secondary battery is used as a power supply for a hybrid vehicle.

### SUMMARY

The invention is set out in the appended set of claims. Embodiments are directed to a battery pack, including a case accommodating at least one cell therein, a strain gage disposed at a surface of the case and having a resistance value varied by a case displacement and a case temperature change, the strain gage including a single resistor having the resistance value varied by the case displacement and the case temperature change, a plurality of first measurement points electrically connected to the resistor and used to detect a change in the resistance value of the resistor according to the case displacement, a plurality of second measurement points electrically connected to the resistor and used to detect a change in the resistance value of the resistor according to the case temperature change, and the plurality of first measurement points and the plurality of second measurement points being spaced apart from each other.

The battery pack may include the resistor having a bar shape extending along a first direction, the plurality of first measurement points facing each other in the first direction, the plurality of second measurement points facing each other in a second direction, and the first direction and the second direction being orthogonal to each other.

The battery pack may include the plurality of second measurement points being adjacent to an electrode tab of the battery pack.

The battery pack may include the resistor including a first portion of a bar shape extending in a first direction and a second portion extending along a second direction orthogonal to the first direction, the plurality of first measurement points being electrically connected to the first portion and face each other in the first direction, and the plurality of second measurement points being electrically connected to the second portion and face each other in the first direction.

The battery pack may include the first portion being disposed at a central portion of the case, the second portion being disposed in an opposite direction to an electrode tab of the battery pack based on the central portion of the case, and the plurality of second measurement points being disposed closer to an outer side than the central portion of the case.

The battery pack may include the first portion being disposed at a central portion of the case, the second portion being adjacent to an electrode tab of the battery pack, and the plurality of second measurement points being adjacent to the electrode tab.

The battery pack may include the resistor further including a third portion extending in a direction opposite to the second portion along the second direction, and the strain gage further including a plurality of third measurement points electrically connected to the third portion and used to detect a change in the resistance value of the resistor according to the case temperature change.

The first portion may be disposed at a central portion of the case, the second portion may be adjacent to an electrode tab of the battery pack, and the plurality of second measurement points may be adjacent to the electrode tab.

The first portion may be disposed at a central portion of the case, the second portion may be disposed in an opposite direction to an electrode tab of the battery pack based on the central portion of the case (40), and the plurality of second measurement points may be disposed closer to an outer side than the central portion of the case.

The battery pack may include the resistor of the strain gage comprising one of a I-shaped form, a L-shaped form or a Z-shaped form with respect to a first plane of the case.

The battery pack may include a protection circuit detecting a displacement amount of the case based on first resistance values measured through the plurality of first measurement points and detecting the temperature based on second resistance values measured through the plurality of second measurement points.

The battery pack may include the protection circuit using a value obtained by subtracting a change amount of the second resistance values from a change amount of the first resistance values to correct the displacement amount.

Embodiments are directed to a battery pack, including a case accommodating at least one cell therein, a strain gage disposed at a surface of the case and having a resistance value varied by a case displacement and a case temperature change, the strain gage including a single resistor having the resistance value varied by the case displacement and the case temperature change, a plurality of first measurement points electrically connected to the resistor and used to detect a change in the resistance value of the resistor according to the case displacement, and a plurality of second measurement points electrically connected to the resistor and used to detect a change in the resistance value of the resistor according to the case temperature change.

The battery pack may include the resistor having a bar shape extending along a first direction, the plurality of first measurement points facing each other in the first direction, the plurality of second measurement points facing each other in a second direction, and the first direction and the second direction being orthogonal to each other.

The battery pack may include the plurality of second measurement points adjacent to an electrode tab of the battery pack.

The battery pack may include the resistor including a first portion of a bar shape extending in a first direction and a second portion extending along a second direction orthogonal to the first direction, the plurality of first measurement points being electrically connected to the first portion and face each other in the first direction, and the plurality of second measurement points being electrically connected to the second portion and facing each other in the first direction.

The battery pack may include the first portion being disposed at a central portion of the case, the second portion being disposed in an opposite direction to an electrode tab of the battery pack based on the central portion of the case, and the plurality of second measurement points being disposed closer to an outer side than the central portion of the case.

The battery pack may include the first portion being disposed at a central portion of the case, the second portion being adjacent to an electrode tab of the battery pack, and the plurality of second measurement points being adjacent to the electrode tab.

The battery pack may include the resistor further including a third portion extending in a direction opposite to the second portion along the second direction, and the strain gage further including a plurality of third measurement points electrically connected to the third portion and used to detect a change in the resistance value of the resistor according to the case temperature change.

The battery pack may include a protection circuit detecting a displacement amount of the case based on first resistance values measured through the plurality of first measurement points and detecting the temperature based on second resistance values measured through the plurality of second measurement points.

The battery pack may include the protection circuit using a value obtained by subtracting a change amount of the second resistance values from a change amount of the first resistance values to correct the displacement amount.

Embodiments are directed to a method of measuring an amount of displacement of a battery pack due to swelling, including measuring, by a plurality of first measurement points electrically connected to a resistor, a change in the resistance value of the resistor according to a case displacement, and measuring, by a plurality of second measurement points electrically connected to the resistor and spaced apart from the plurality of first measurement points, a change in the resistance value of the resistor according to a case temperature change.

The method may include measuring, by a plurality of third measurement points electrically connected to the resistor, a change in the resistance value of the resistor according to the case temperature change.

The method may include the battery pack referring to the battery pack as disclosed herein.

### BRIEF DESCRIPTION OF THE DRAWINGS

Features will become apparent to those of skill in the art by describing in detail exemplary embodiments with reference to the attached drawings, in which:
FIG. 1 is a block diagram showing an example embodiment of a battery pack; and
FIGS. 2-6 are cross-sectional diagrams showing example embodiments of a battery pack.

### DETAILED DESCRIPTION

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey exemplary implementations to those skilled in the art.

In the drawing figures, the dimensions of layers and regions may be exaggerated for clarity of illustration. It will also be understood that when a layer or element is referred to as being "on" another layer or substrate, it can be directly on the other layer or substrate, or intervening layers may also be present. Further, it will be understood that when a layer is referred to as being "under" another layer, it can be directly under, and one or more intervening layers may also be present. In addition, it will also be understood that when a layer is referred to as being "between" two layers, it can be the only layer between the two layers, or one or more intervening layers may also be present. Like reference numerals refer to like elements throughout.

In the present specification, the term "and/or" includes all or random combinations of a plurality of items that are related and arranged. When the embodiments of the present disclosure are described, the use of "can" or "may" signifies at least one embodiment of the present disclosure. In the following description of the embodiments of the present disclosure, a singular term may include a plural form unless stated in another way.

In the present specification, terms including ordinal numbers such as first, second, and third will be used only to describe various components and are not to be interpreted as limiting these components. The terms are only used to differentiate one component from other components. For example, a first constituent element could be termed a second constituent element, and similarly, a second constituent element could be termed a first constituent element, without departing from the scope of the present disclosure.

It will be understood that when a constituent element or layer is referred to as being "on," "connected to," or "coupled to" another constituent element or layer, it may be directly on, connected to, or coupled to the other constituent element or layer, or one or more intervening constituent elements or layers may be present. It will also be understood that when a constituent element or layer is referred to as being "between" two constituent elements or layers, it may be the only constituent element or layer between the two constituent elements or layers, or one or more intervening constituent elements or layers may also be present.

Electrically connecting two constituent elements may include directly connecting two constituent elements and connecting the same with another constituent element therebetween. The other constituent element may include a switch, a resistor, or a capacitor. When the embodiments are described, an expression of connection signifies electrical connection when an expression of direct connection is not provided. As used herein, the term "or" is not an exclusive term, e.g., "A or B" would include A, B, or A and B.

Hereinafter, a battery pack according to embodiments will be described in detail with reference to the drawings.

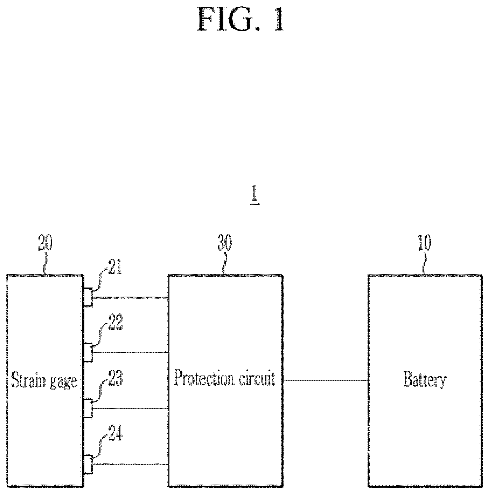

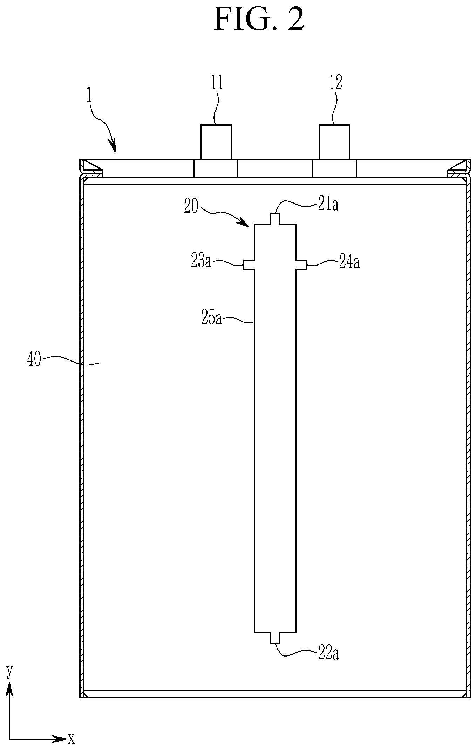

FIG. 1 is a block diagram showing an example embodiment of a battery pack 1. Referring to FIG. 1, the battery pack 1 may include a battery 10, a strain gage (or a strain gauge) 20, and a protection circuit 30. The battery 10 may include at least one cell. The at least one cell may be accommodated in a space inside a case 40 of FIGS. 2 to 6 of the battery pack 1.

The strain gage 20 may include a single resistor with a variable resistance value varying according to displacement and temperature. The resistor of the strain gage 20 may include single crystal silicon (Si). The resistor including single crystal silicon (Si) may have a variable resistance value according to a displacement amount and the temperature.

The strain gage 20 may be thin. In an implementation, after the resistor of the strain gage 20 is formed on a polyimide film, the resistor formed on the polyimide film may be attached to a surface of a measuring object. A displacement of the battery pack 1 may be measured through a separate adhesive member. The strain gage 20 may be directly formed on the surface of the case 40 of the battery pack 1 without using a separate polyimide layer or the separate adhesive member. In an implementation, the strain gage 20 may be directly formed on the surface of the case 40 by a stamping method using a polydimethylsiloxane (PDMS) stamp.

The strain gage 20 may include a plurality of measurement points, such as a first measurement point 21, a second measurement point 22, a third measurement point 23, and a fourth measurement point 24 spaced apart from each other. Each of the plurality of measurement points 21- 24 may be electrically connected to the single resistor included in the strain gage 20. Some of the plurality of measurement points (e.g., first measurement point 21 and second measurement point 22) may be set as displacement measurement points to detect a change in a resistance value of the strain gage 20 according to a displacement of the battery pack 1. The remaining measurement points (e.g., third measurement point 23 and fourth measurement point 24) of the plurality of measurement points may be set as temperature measurement points to detect a change in a resistance value of the strain gage 20 according to a change in a temperature of the battery pack 1.

The protection circuit 30 may perform a charging and discharging control function, a protection function from overvoltage, overdischarge, or short circuit, or a cell balancing function of the battery 10. In an implementation, the protection circuit 30 may be electrically connected to the measurement points 21, 22, 23, and 24 of the strain gage 20 so that a resistance value of the resistor of the strain gage 20 may be detected. The protection circuit 30 may detect a displacement amount and a temperature of the battery pack 1 based on resistance values detected through the measurement points 21-24. If the displacement amount and the temperature of the battery pack 1 are detected through the strain gage 20, the protection circuit 30 may perform a protection operation based on the displacement amount and the temperature of the battery pack 1 or may transmit information on the detected displacement and temperature to a controller of a load using the battery pack 1 as an electric power source.

The protection circuit 30 may detect the temperature of the battery pack 1 using resistance values detected from the third and fourth temperature measurement points 23 and 24. In an implementation, the battery pack 1 may not include a separate temperature sensor to measure the temperature of the battery pack 1.

The protection circuit 30 may obtain the amount of displacement of the battery pack 1 (or the case of the battery pack 1) using resistance values detected from the first and second displacement measurement points 21 and 22. The protection circuit 30 may perform temperature compensation on the resistance values detected through the first and second displacement measurement points 21 and 22 using the resistance values detected through the third and fourth temperature measurement points 23 and 24 in order to improve displacement amount detection accuracy. In an implementation, the protection circuit 30 may subtract a change amount of the resistance values detected through the third and fourth temperature measurement points 23 and 24 from a change amount of the resistance values detected through the first and second displacement measurement points 21 and 22 and may obtain the displacement amount using the subtracted result. In some embodiments, the displacement amount detection accuracy may be improved by removing a change due to the temperature from a change in the resistance values measured through the first and second displacement measurement points 21 and 22.

In other embodiments, the first and second displacement measurement points 21 and 22 may be disposed at a point where the change in the resistance values of the strain gage 20 according to the amount of displacement of the case during swelling of the battery pack 1 is the largest. In an implementation, the third and fourth temperature measurement points 23 and 24 may be disposed at a point where the change in the resistance values of the strain gage 20 according to the amount of displacement of the case during swelling of the battery pack 1 is the smallest and the change in the resistance values of the strain gage 20 according to a change in a temperature of the case is measured as relatively large.

Hereinafter, embodiments of disposing the plurality of measurement points 21-24 of the strain gage 20 will be described with reference to FIGS. 2 to 6. FIGS. 2-6 are cross-sectional views showing example embodiments of a battery pack in which a strain gage is disposed. Referring to FIG. 2, the strain gage 20 may include the first resistor 25a on a surface of the case 40 of the battery pack 1. The first resistor 25a may be a rectangular bar shape extending in a y-axis direction from a central portion of the case 40. In other words, the resistor of the strain gage 20 may comprise a substantially I-shaped form with respect to the x-y plane.

The second set of measurement points 21a, 22a, 23a, and 24a of the strain gage 20 may be spaced apart from each other and may protrude from the bar-shaped first resistor 25a in the y-axis direction and/or an x-axis direction. Preferably, the measurement points 21a, 22a, 23a, and 24a of the strain gage 20 may be evenly distributed between the sides of the strain gage 20 along the x- and y axes. In other words, the strain gage 20 may include one of the measurement points 21a, 22a, 23a, and 24a on each side along the x- and y-axes.

The second set displacement measurement points 21a and 22a of the strain gage 20 may face each other in the y-axis direction. In other words, the second set displacement measurement points 21a and 22a may be arranged on opposite sides of the strain gage 20 with respect to the y-axis. The second set temperature measurement points 23a and 24a of the strain gage 20 may face each other in a direction of an x-axis orthogonal to a y-axis. In other words, the second set temperature measurement points 23a and 24a may be arranged on opposite sides of the strain gage 20 with respect to the x-axis. The second set temperature measurement points 23a and 24a may be adjacent to first and second electrode tabs 11 and 12. In other words, second set temperature measurement points 23a and 24a may be arranged on a side of the strain gage 20 facing the first and second electrode tabs 11 and 12 and/or being adjacent to the first and second electrode tabs 11 and 12. In an implementation, the second set temperature measurement points 23a and 24a may be disposed in a same direction as the first and second electrode tabs 11 and 12 of the battery pack 1 are disposed based on a center of the case 40. In other words, the second set temperature measurement points 23a and 24a may be disposed to be spaced apart from each other in a same direction as the first and second electrode tabs 11 and 12 of the battery pack 1 are spaced apart from each other.

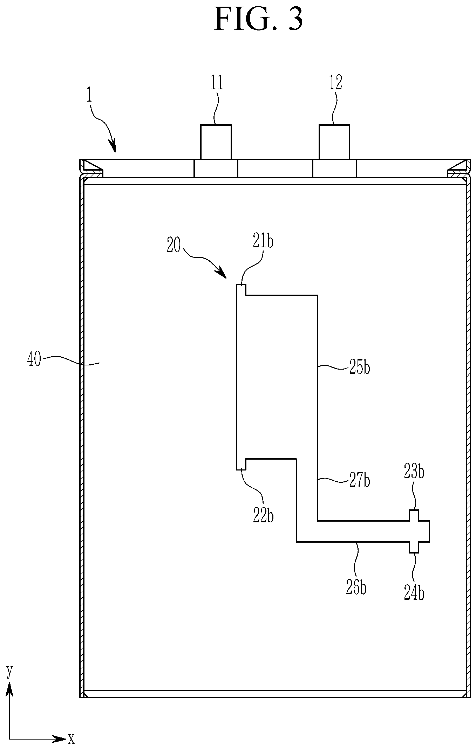

Referring to FIG. 3, the resistor of the strain gage 20 may include a second resistor first portion 25b having a rectangular bar shape extending in the y-axis direction from a central portion of the case 40, a second resistor second portion 26b having a rectangular bar shape protruding and extending in the x-axis direction from the first portion 25b, and a second resistor connection portion 27b connecting the second resistor first portion 25b and the second resistor second portion 26b. In other words, the resistor of the strain gage 20 may comprise a substantially L-shaped form with respect to the x-y plane. The second resistor first portion 25b, the second resistor second portion 26b, and the second resistor connection portion 27b may form a single resistor (e.g., a second resistor). The second resistor second portion 26b may be disposed in an opposite direction to the first and second electrode tabs 11 and 12 based on the center of the case 40. A width of the x-axis direction of the second resistor first portion 25b may be greater than a width of the y-axis direction of the second resistor second portion 26b. For example, the width of the x-axis direction of the second resistor first portion 25b may be more than 1,5 times, preferably more than two times, particularly preferred more than three times of the width of the y-axis direction of the second resistor second portion 26b.

The third set of measurement points 21b, 22b, 23b, and 24b of the strain gage 20 may be spaced apart from each other and may protrude from the resistor in the y-axis direction. The third set displacement measurement points 21b and 22b may protrude in the y-axis direction from the first portion 25b of the resistor. In other words, the third set displacement measurement points 21b and 22b may be arranged on opposite sides of the strain gage 20 with respect to the y-axis. The third set temperature measurement points 23b and 24b may protrude in the y-axis direction from the second portion 26b of the resistor. In other words, the third set displacement measurement points 23b and 24b may be arranged on opposite sides from the second portion 26b of the resistor with respect to the y-axis.

The third set displacement measurement points 21b and 22b of the strain gage 20 may face each other in the y-axis direction. In other words, the third set displacement measurement points 21b and 22b may be arranged on opposite sides of the strain gage 20 with respect to the y-axis. The third set temperature measurement points 23b and 24b of the strain gage 20 may face each other in the y-axis direction. In other words, the third set displacement measurement points 23b and 24b may be arranged on opposite sides of the strain gage 20 with respect to the y-axis. That is, the opposite directions of the third set displacement measurement points 21b and 22b and the third set temperature measurement points 23b and 24b may be parallel to each other.

The third set temperature measurement points 23b and 24b may be closer to an outer side of the case 40 than a central portion of the case 40 so that the third set temperature measurement points 23b and 24b are relatively insensitive to displacement of the case 40 due to swelling of the battery pack 1. For example, the first portion 25b of the resistor may be arranged to partially overlap the center of the case 40, whereas the second portion 26b of the resistor may be arranged to not overlap the center of the case 40.For example, the third set temperature measurement points 23b and 24b may be arranged in an area of the case 40 corresponding to the outer quarter of the case 40 with respect to the x-axis.

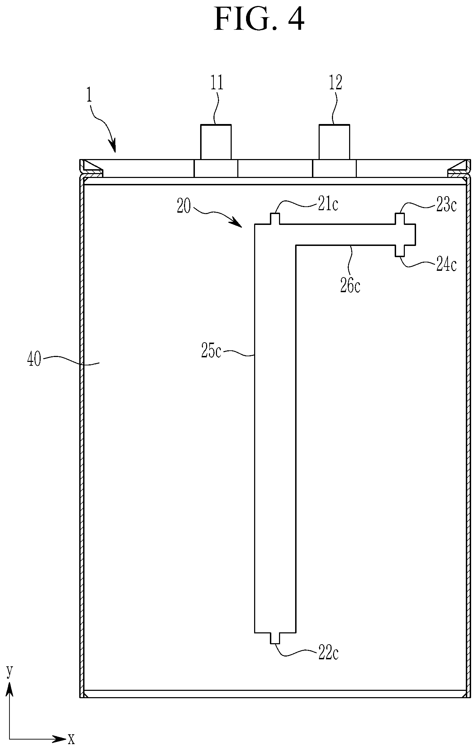

Referring to FIG. 4, the third resistor of the strain gage 20 may include a third resistor first portion 25c having a rectangular bar shape extending in the y-axis direction from a central portion of the case 40 and a third resistor second portion 26c having a rectangular bar shape protruding and extending in the x-axis direction from the third resistor first portion 25c. In other words, the third resistor of the strain gage 20 may comprise a substantially L-shaped form with respect to the x-y plane. The third resistor first portion 25c, and the third resistor second portion 26c may form a single resistor (e.g., a third resistor). The third resistor first portion 25c may be disposed to protrude away from the first electrode tab 11 and the second electrode tab 12. In other words, the third resistor first portion 25c may be arranged to extend in the x-axis direction. The third resistor second portion 26c may be adjacent to the second electrode tab 12. In other words, the third resistor second portion 26c may protrude away from the first electrode tab 11 in the x-axis direction. In an implementation, the third resistor second portion 26c may be disposed at a side of the second electrode tab 12 based on the central portion of the case 40. In other words, the third resistor second portion 26c may be disposed in an area of the case 40 corresponding to one half of the case 40 with respect to the x-axis, wherein the half of the case 40 corresponds to the second electrode tab 12.

The fourth set of measurement points 21c, 22c, 23c, and 24c of the strain gage 20 may be spaced apart from each other and may protrude from the third resistor in the y-axis direction. The fourth set displacement measurement points 21c and 22c may protrude in the y-axis direction from the first portion 25c of the resistor. In other words, the fourth set displacement measurement points 21c and 22c may be arranged on opposite sides of the strain gage 20 with respect to the y-axis. The fourth set temperature measurement points 23c and 24c may protrude in the y-axis direction from the third resistor second portion 26c of the third resistor. In other words, the fourth set temperature measurement points 23c and 24c may be arranged on opposite sides of the strain gage 20 with respect to the y-axis. That is, the opposite directions of fourth set displacement measurement points 21c and 22c and the fourth set temperature measurement points 23c and 24c may be parallel to each other.

The fourth set displacement measurement points 21c and 22c of the strain gage 20 may face each other in the y-axis direction. In other words, the fourth set displacement measurement points 21c and 22c may be arranged on opposite sides of the strain gage 20 with respect to the y-axis. The fourth set temperature measurement points 23c and 24c of the strain gage 20 may face each other in the y-axis direction. In other words, the fourth set temperature measurement points 23c and 24c may be arranged on opposite sides of the strain gage 20 with respect to the y-axis.

Because the third resistor second portion 26c may extend to a side of the electrode tab 12, the fourth set temperature measurement points 23c and 24c may be adj acent to the second electrode tab 12 so that the fourth set temperature measurement points 23c and 24c sensitively respond to a temperature change of the second electrode tab 12.

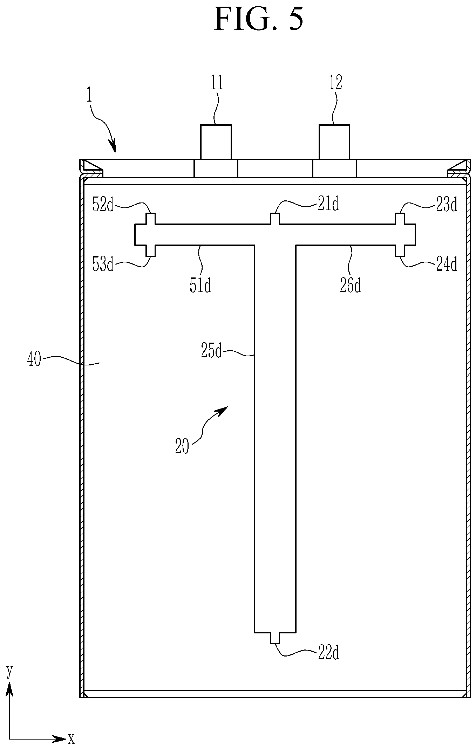

Referring to FIG. 5, the fourth resistor of the strain gage 20 may include a fourth resistor first portion 25d having a rectangular bar shape extending in the y-axis direction from a central portion of the case 40, a fourth resistor second portion 26d having a rectangular bar shape protruding and extending in the x-axis direction from the fourth resistor first portion 25d, and a fourth resistor third portion 51d having a rectangular bar shape protruding and extending in the x-axis direction from the fourth resistor first portion 25d. In other words, the fourth resistor of the strain gage 20 may comprise a substantially T-shaped form with respect to the x-y plane. The fourth resistor first portion 25d, the fourth resistor second portion 26d, and the fourth resistor third portion 51d may form a single resistor (e.g., a fourth resistor). The fourth resistor second portion 26d and the fourth resistor third portion 51d may extend in opposite directions with respect to the fourth resistor first portion 25d. The fourth resistor second portion 26d may be disposed in a direction adjacent to the second electrode tab 12 based on the central portion of the case 40. The fourth resistor third portion 51d may be disposed in a direction adjacent to the first electrode tab 11 based on the central portion of the case 40. In other words, the fourth resistor second portion 26d may be disposed in an area of the case 40 corresponding to one half of the case 40 with respect to the x-axis, wherein the half of the case 40 corresponds to the second electrode tab 12. The fourth resistor third portion 51d may be disposed in an area of the case 40 corresponding to the other half of the case 40 with respect to the x-axis, wherein the other half of the case 40 corresponds to the first electrode tab 11.

The strain gage 20 may further include the sixth set temperature measurement points 52d and 53d in addition to the fifth set displacement measurement points 21d and 22d and the fifth set temperature measurement points 23d and 24d. The fifth set of measurement points 21d, 22d, 23d, 24d, and the sixth set of temperature measurement points 52d, and 53d may be spaced apart from each other, and may protrude from the fourth resistor in the y-axis direction. The fifth set displacement measurement points 21d and 22d may be arranged analogously to the fifth set of measurement points 23d, 24d (mirror symmetry with respect to the y-axis). The fifth set displacement measurement points 21d and 22d may protrude in the y-axis direction from the fourth resistor first portion 25d of the fourth resistor. The fifth set temperature measurement points 23d and 24d may protrude in the y-axis direction from the fourth resistor second portion 26d of the fourth resistor. The sixth set temperature measurement points 52d and 53d may protrude in the y-axis direction from the fourth resistor third portion 51d of the fourth resistor.

The fifth set displacement measurement points 21d and 22d of the strain gage 20 may face each other in the y-axis direction. The fifth set temperature measurement points 23d and 24d of the strain gage 20 may face each other in the y-axis direction. The sixth set temperature measurement points 52d and 53d of the strain gage 20 may face each other in the y-axis direction.

Because the fourth resistor second portion 26d may extend to a side of the second electrode tab 12, the fifth set temperature measurement points 23d and 24d may be adjacent to the second electrode tab 12 so that the fifth set temperature measurement points 23d and 24d sensitively respond to a temperature change of the second electrode tab 12. Because the fourth resistor third portion 51d may extend to a side of the first electrode tab 11, the sixth set temperature measurement points 52d and 53d may be adjacent to the first electrode tab 11 so that the sixth set temperature measurement points 52d and 53d sensitively respond to a temperature change of the first electrode tab 11.

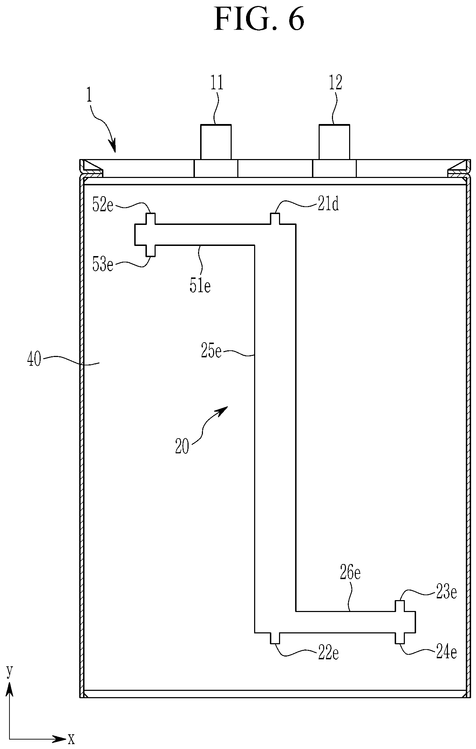

Referring to FIG. 6, the resistor of the strain gage 20 may include a fifth resistor first portion 25e having a rectangular bar shape extending in the y-axis direction from a central portion of the case 40, a fifth resistor second portion 26e having a rectangular bar shape protruding and extending in the x-axis direction from the fifth resistor first portion 25e, and a fifth resistor third portion 51e having a rectangular bar shape protruding and extending in the x-axis direction from the fifth resistor first portion 25e. The fifth resistor first portion 25e, the fifth resistor second portion 26e, and the fifth resistor third portion 51e may form a single resistor (e.g., a fifth resistor). The resistor of the strain gage 20 may comprise a substantially Z-shaped form with substantially right angles with respect to the x-y plane. For example, the shape of the resistor of the strain gage 20 is radially symmetric with respect to the x-y plane (point symmetry). The fifth resistor second portion 26e and the fifth resistor third portion 51e may extend in opposite directions with respect to the fifth resistor first portion 25e and may be coupled to different end portions of the fifth resistor first portion 25e. The fifth resistor second portion 26e may be disposed in an opposite direction to the first and second electrode tabs 11 and 12 based on the central portion of the case 40. The fifth resistor third portion 51e may be disposed in a direction in which the first and second electrode tabs 11 and 12 are disposed based on the central portion of the case 40. The fifth resistor third portion 51e may be adjacent to the first electrode tab 11. In other words, the fifth resistor second portion 26e may be disposed in an area of the case 40 corresponding to one half of the case 40 with respect to the x-axis, wherein the half of the case 40 corresponds to the second electrode tab 12. The fifth resistor third portion 51e may be disposed in an area of the case 40 corresponding to the other half of the case 40 with respect to the x-axis, wherein the other half of the case 40 corresponds to the first electrode tab 11.

The strain gage 20 may include the sixth set displacement measurement points 21e and 22e and the seventh and eighth set temperature measurement points 23e, 24e, 52e, and 53e. The sets of measurement points 21e, 22e, 23e, 24e, 52e, and 53e may be spaced apart from each other, and may protrude from the fifth resistor in the y-axis direction. The sixth set displacement measurement points 21e and 22e may protrude in the y-axis direction from the fifth resistor first portion 25e of the fifth resistor. In other words, the sixth set displacement measurement points 21e and 22e may be arranged on opposite sides of the strain gage 20 with respect to the y-axis. The seventh set temperature measurement points 23e and 24e may protrude in the y-axis direction from the fifth resistor second portion 26e of the fifth resistor. In other words, the seventh set temperature measurement points 23e and 24e may be arranged on opposite sides of the strain gage 20 with respect to the y-axis. The eighth set temperature measurement points 52e and 53e may protrude in the y-axis direction from the fifth resistor third portion 51e of the fifth resistor. In other words, the eighth set temperature measurement points 52e and 53e may be arranged on opposite sides of the strain gage 20 with respect to the y-axis. That is, the opposite directions of the sixth set displacement measurement points 21e and 22e, the seventh set temperature measurement points 23e and 24e and the eighth set temperature measurement points 52e and 53e may be parallel to each other.

The sixth set displacement measurement points 21e and 22e of the strain gage 20 may face each other in the y-axis direction. In other words, the sixth set displacement measurement points 21e and 22e may be arranged on opposite sides of the strain gage 20 with respect to the y-axis. The seventh set temperature measurement points 23e and 24e of the strain gage 20 may face each other in the y-axis direction. In other words, the seventh set temperature measurement points 23e and 24e may be arranged on opposite sides of the strain gage 20 with respect to the y-axis. The eighth set temperature measurement points 52e and 53e of the strain gage 20 may face each other in the y-axis direction. In other words, the eighth set temperature measurement points 52e and 53e may be arranged on opposite sides of the strain gage 20 with respect to the y-axis.

Because the fifth resistor second portion 26e may extend to an outer side of the case 40, the seventh set temperature measurement points 23e and 24e may insensitively respond to displacement of the case 40 due to swelling of the battery pack 1. Because the fifth resistor third portion 51e may extend to a side of the first electrode tab 11, the eighth set temperature measurement points 52e and 53e may be adjacent to the first electrode tab 11 so that the eighth set temperature measurement points 52e and 53e sensitively respond to a temperature change of the first electrode tab 11.

Referring to the above embodiments, the temperature measurement points of the strain gage 20 may be disposed in various ways depending on a position of a portion (e.g., the first and second electrode tabs 11 and 12) where a large temperature change occurs in the battery pack 1 or a portion (e.g., an outer periphery of the case 40) where the displacement of the case 40 is the smallest due to swelling. For example, the strain gage 20 may be transformed into various shapes depending on disposition positions of the temperature measurement points.

According to the above-described embodiments, it is possible to detect the temperature of the battery pack 1 as well as the amount of displacement of the battery pack 1 using the strain gage 20 including the single resistor. For example, a separate process for mounting a temperature sensor at the battery pack 1 may not be required so that complexity of a manufacturing process of the battery pack 1 is reduced. In some embodiments, if the displacement amount is detected using the strain gage 20, displacement amount measurement accuracy may be improved by compensating for the change in the resistance value due to the temperature.

Electronic or electrical devices according to embodiments of the present disclosure and/or other related devices or constituent elements may be realized by using appropriate hardware, firmware (e.g., an application-specific integrated circuit), software, or combinations of software, firmware, and hardware. For example, various configurations of the above-noted devices may be disposed on one integrated circuit (IC) chip or an individual IC chip. In addition, various configurations of the above-noted devices may be realized on a flexible printed circuit film, a tape carrier package (TCP), a printed circuit board (PCB), or one substrate. The electrical or mutual connections described in the present specification may, for example, be realized by the PCB, wires on different types of circuit carriers, or conductive elements. The conductive elements may, for example, include metallization such as surface metallizations and/or pins, and may include conductive polymers or ceramics. Further, electrical energy may be transmitted via wireless connection, e.g., using electromagnetic radiation or light.

In addition, the various configurations of the devices may be performed by at least one processor to perform the above-described various functions, they may be performed in at least one computing device, and they may be processes or threads for performing computer program instructions and interacting with other system constituent elements. The computer program instruction is stored in a memory realizable in a computing device using a standard memory device such as a random access memory (RAM). The computer program instruction may also be stored in a non-transitory computer readable medium such as a CD-ROM or a flash drive.

By way of summation and review, in general, a secondary battery cell may include an electrode assembly including a positive electrode, a negative electrode, and a separator interposed between the positive electrode and the negative electrode, a case accommodating the electrode assembly, and an electrode terminal electrically connected to the electrode assembly. An electrolyte solution may be injected into the case to enable charging and discharging of the battery cell through an electrochemical reaction between the positive electrode, the negative electrode, and the electrolyte solution. A shape of the case such as a cylindrical or rectangular shape may vary depending on a use of the battery cell.

A swelling phenomenon may occur in the secondary battery due to repeated charging and discharging. Swelling is a phenomenon in which the secondary battery swells due to a gas generated inside the secondary battery and is directly related to safety of the secondary battery. A problem to be solved through embodiments is to provide a battery pack capable of improving accuracy of measuring an amount of displacement of the battery pack due to swelling. Accuracy of measuring an amount of displacement of a battery pack due to swelling may be improved. It is possible to simplify an assembly process of the battery pack and reduce a manufacturing cost of the battery pack.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A battery pack (1), comprising:
a case (40) accommodating at least one cell therein;
a strain gage (20) disposed at a surface of the case (40) and having a resistance value varied by a case displacement and a case temperature change, the strain gage (20) including a single resistor having the resistance value varied by the case displacement and the case temperature change;
a plurality of first measurement points (21, 22) electrically connected to the resistor and used to detect a change in the resistance value of the resistor according to the case displacement;
a plurality of second measurement points (23, 24) electrically connected to the resistor and used to detect a change in the resistance value of the resistor according to the case temperature change; and
the plurality of first measurement points (21, 22) and the plurality of second measurement points (23, 24) being spaced apart from each other.

2. The battery pack (1) as claimed in claim 1, wherein:
the resistor has a bar shape extending along a first direction,
the plurality of first measurement points (21a, 22a) face each other in the first direction,
the plurality of second measurement points (23a, 24a) face each other in a second direction, and
the first direction and the second direction are orthogonal to each other.

3. The battery pack (1) as claimed in claim 2, wherein the plurality of second measurement points (23a, 24a) are adjacent to an electrode tab (11, 12) of the battery pack (1).

4. The battery pack (1) as claimed in claim 1, wherein:
the resistor includes a first portion (25b, c, d, e) of a bar shape extending in a first direction and a second portion (26b, c, d, e) extending along a second direction orthogonal to the first direction,
the plurality of first measurement points (21b, c, d, e, 22b, c, d, e) are electrically connected to the first portion (25b, c, d, e) and face each other in the first direction, and
the plurality of second measurement points (23b, c, d, e, 24b, c, d, e) are electrically connected to the second portion (26b, c, d, e) and face each other in the first direction.

5. The battery pack (1) as claimed in claim 4, wherein:
the first portion (25b, c, d, e) is disposed at a central portion of the case (40),
the second portion (26b, e) is disposed in an opposite direction to an electrode tab (11, 12) of the battery pack (1) based on the central portion of the case (40), and
the plurality of second measurement points (23b, e, 24b, e) are disposed closer to an outer side than the central portion of the case (40).

6. The battery pack (1) as claimed in claim 4, wherein:
the first portion (25b, c, d, e) is disposed at a central portion of the case (40),
the second portion (26c, d) is adjacent to an electrode tab (11, 12) of the battery pack (1), and
the plurality of second measurement points (23c, d, 24c, d) are adjacent to the electrode tab (11, 12).

7. The battery pack (1) as claimed in claim 4, wherein:
the resistor further includes a third portion (51d, e) extending in a direction opposite to the second portion (26d, e) along the second direction, and
the strain gage (20) further includes a plurality of third measurement points (52d, e, 53d, e) electrically connected to the third portion (51d, e) and used to detect a change in the resistance value of the resistor according to the case temperature change.

8. The battery pack (1) as claimed in claim 7, wherein:
the first portion (25d) is disposed at a central portion of the case (40),
the second portion (26d) is adjacent to an electrode tab (11, 12) of the battery pack (1), and
the plurality of second measurement points (23d, 24d) are adjacent to the electrode tab (11, 12).

9. The battery pack (1) as claimed in claim 7, wherein:
the first portion (25e) is disposed at a central portion of the case (40),
the second portion (26e) is disposed in an opposite direction to an electrode tab (11, 12) of the battery pack (1) based on the central portion of the case (40), and
the plurality of second measurement points (23e, 24e) are disposed closer to an outer side than the central portion of the case (40).

10. The battery pack (1) as claimed in any one of the preceding claims, wherein the resistor of the strain gage (20) comprises one of a I-shaped form, a L-shaped form or a Z-shaped form with respect to a first plane of the case (40).

11. The battery pack (1) as claimed in any one of the preceding claims, further comprising a protection circuit (30) detecting a displacement amount of the case (40) based on first resistance values measured through the plurality of first measurement points (21, 22) and detecting the temperature based on second resistance values measured through the plurality of second measurement points (23, 24).

12. The battery pack (1) as claimed in claim 11, wherein the protection circuit (30) uses a value obtained by subtracting a change amount of the second resistance values from a change amount of the first resistance values to correct the displacement amount.

13. A method of measuring an amount of displacement of a battery pack (1) due to swelling, comprising:
measuring, by a plurality of first measurement points (21, 22) electrically connected to a resistor, a change in the resistance value of the resistor according to a case displacement; and
measuring, by a plurality of second measurement points (23, 24) electrically connected to the resistor and spaced apart from the plurality of first measurement points (21), a change in the resistance value of the resistor according to a case temperature change.

14. The method as claimed in claim 13, further comprising measuring, by a plurality of third measurement points (52d, e, 53d, e) electrically connected to the resistor, a change in the resistance value of the resistor according to the case temperature change.

15. The method as claimed in claim 13 or 14, wherein the battery pack (1) refers to the battery pack (1) of any one of the claims 1 to 12.
